# EUROPEAN PATENT APPLICATION

(11) **EP 1 914 596 A2**
(43) Date of publication of application: **23.04.2008**
(21) Application number: 07024032.0
(22) Date of filing: 21.07.2004
(51) Int. Cl.: G03F 7/004

(54) **Dissolution inhibitors in photoresist compositions for microlithography**

(30) Priority: 23.07.2003 EP 03102269
(62) Divisional of application: 04774830.6
(71) Applicant: DSM IP Assets B.V., 6411 TE Heerlen (NL)
(72) Inventor: Shahab, Jahromi, 6211 PA Maastricht (NL); Derks, Franciscus Johannes Marie, 6093 DK Heythuysen (NL); Lyapunov, Andrey Yaroslavovich, 119333 Moscow (RU)
(74) Representative: van der Ploeg, Antonius Franciscus M.J.

(57) **Abstract**

The invention relates to a process for the production of a chip by using immersion lithography, comprising the step of forming a photoresist layer on a substrate, wherein the photoresist layer is prepared from a photoresist composition comprising:
(a) a binder;
(b) a photoactive component.
(c) a fluor containing compound.

## Description

The present invention relates to dissolution inhibitors in photoresist compositions comprising a polymeric binder, a dissolution inhibitor and a photo active compound, suitable for use with lasers predominantly generating radiation with a wavelength of between 10-165 nm, in particular of 157 nm.

Such photoresist compositions are described in J. Photopol. Sc. & Techn. 15 (2002), pages 613-618. More in particular, said journal article describes the use of fluorinated norbornene type of polymers and a number of dissolution inhibitors having an aliphatic, or aromatic ring structure. Said article is describing compositions for use in photoresist technology working with a wavelength of 157 nm (currently obtained with a fluorine excimer laser). Photoresist technology at this wavelength is requiring new materials and compositions that are transparent at that wavelength, that are highly sensitive to the radiation and in the further development step, sensitive to the developer solution, and yet at the undeveloped areas, a good etch resistance. The next step in lower wavelength will be extreme UV (13 nm).

The currently known materials are not meeting all the requirements and research is ongoing to find better polymeric binders, dissolution inhibitors or other additives giving improved results and improved photo active compounds, suitable for use at the wavelength below 165 nm.

It is one object of the present invention to provide an improved dissolution inhibitor.

It is a further object of the present invention to provide a photoresist composition suitable for use at 157 nm having improved properties.

One or more of the above objects are achieved by a photoresist composition suitable for use at 10-165 nm comprising:
(a) a polymeric binder
(b) a photoactive compound
(c) a dissolution inhibitor, the dissolution inhibitor comprising at least
   (i) two aromatic groups,
   (ii) fluorine and
   (iii) a (blocked) acid group which when unblocked has a pKa < 12.

Unexpectedly, the dissolution inhibitor as defined under (c) had better performance in etch resistance and/or resistance against swelling in developer solutionthan the dissolution inhibitors described in the prior art.

Part of the dissolution inhibitors found are novel compounds, and are represented by formula 1. 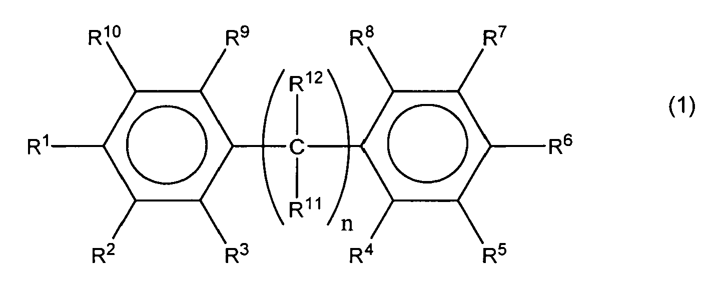 in which n = 1-4
at least one of R¹ through R¹⁰ independently comprise a (blocked) acid group, the acid group when unblocked has a pKa < 12. Preferably, the at least one R¹-R¹⁰ independently comprise hydroxy, C(CF₃)₂OH, or an acid labile group, more preferebly the acid labile group is represented by any of formula's (2)-(5); 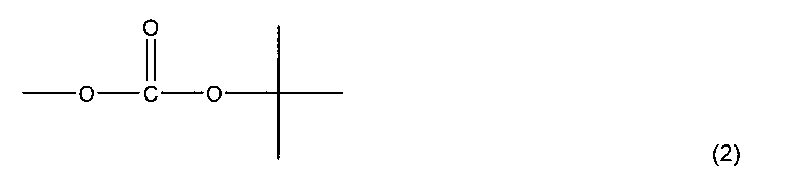 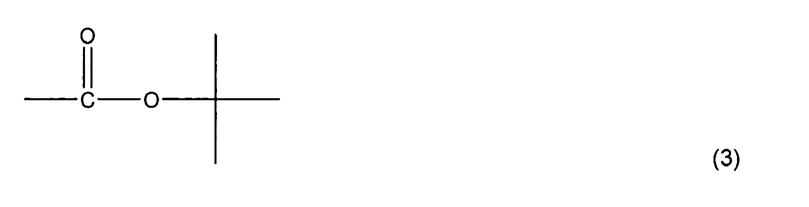 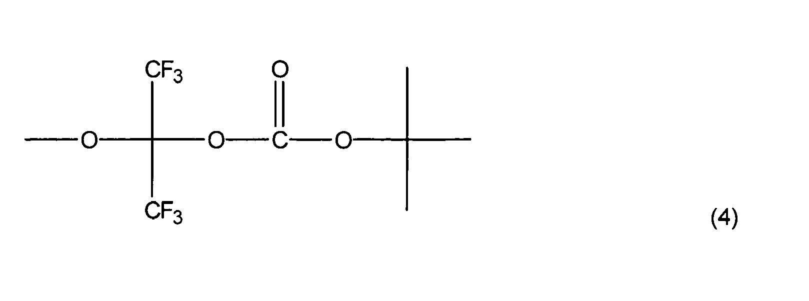 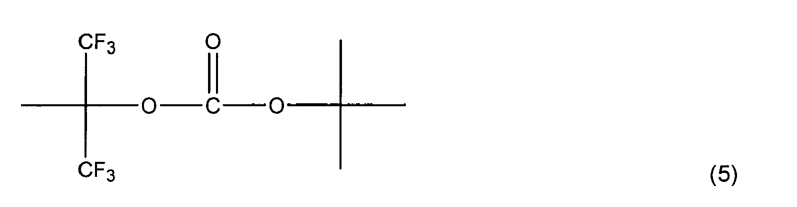 the other R¹ through R¹⁰ represent independently hydrogen, fluorine or hydrocarbonaceous substituents;
R¹¹ is an aliphatic fluorinated group preferably having 2-10 carbon atoms and 2-20 fluorine atoms;
R¹² represents hydrogen or an aliphatic group having 1-10 carbon atoms and 0-13 fluorine atoms, and R¹¹ and R¹² are not both CF₃.

In formula 1:
One of R¹-R³ and R⁹-R¹⁰ and one of R⁴-R⁸, independently, are preferably hydroxy, C(CF₃)₂OH or an acid labile group;
the other R¹ through R¹⁰, independently, preferably are hydrogen.
R¹¹ preferably is a fluorinated C₂-C₁₀ group with 2-20 fluor atoms, more preferably linear group.
R¹² preferably is hydrogen.

In the photoresist composition of the present invention, the polymeric binder (a) generally is a low molecular weight polymer. Hence, it is sometimes called an oligomer. The polymeric binder can be any suitable binder which is transparent at 10-165 nm, in particular 13 or 157 nm. The binder preferably has an absorption at the used wavelength lower 5 µm⁻¹, more preferably lower than 4 µm⁻¹, more preferably 3 µm⁻¹, even more preferably 2 µm⁻¹, and even more preferably below 1 µm⁻¹. Nowadays commonly investigated are fluorinated norbornene type of polymers and siloxane based polymers for 157 nm.

Such an oligomer preferably has a number average molecular weight of about 5000 or less. As is well known to those skilled in the art, certain ethylenically unsaturated compounds (monomers) undergo free radical polymerization or metal-catalyzed addition polymerization to form polymers having repeat unit(s) derived from the ethylenically unsaturated compounds. By suitable adjustments in polymerization conditions and especially by employing a chain transfer agent or chain terminating agent in the synthesis, the molecular weight of the product may be controlled to the desired range.

The polymer comprises acid groups (with a pKa < 12), which are preferably partially blocked with acid-labile groups. Generally 5-90% of the acid groups is blocked, preferably 6-50% and most preferably 6-30%, with the percentage of blocking it is possible to optimise the sensitivity of the polymer for UV light.

Suitable polymers are fluorinated hydrocarbon polymers. Preferably the hydrocarbon polymers comprises ring structures such as for example tetrahydrofurane of norbornane. Examples of suitable polymers comprise polynorbornene hexafluoralcohol, or a polymer developped by Asahi with the structure 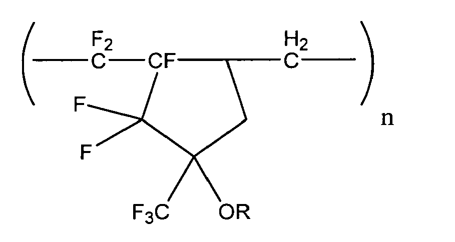 in which R is H or t-boc (the polymer contains both hydroxy and blocked hydroxy groups).

### Photoactive Compound (PAC)

The photoresist composition contains a combination of binder (a) and photoactive compound (b).

If the polymer of the binder itself is photoactive, a separate photoactive component is not required. It is contemplated that the photoactive component may be chemically bonded to the polymer of the binder. A system in which the polymeric binder itself is photochemically active is described in EP-A-473547. Therein a photoresist comprises an olefinically unsaturated sulfonium or iodonium salt (the photochemically active component) copolymerized with an olefinically unsaturated comonomer containing an acid sensitive group yielding a radiationsensitive copolymer that would be an effective photoactive polymeric binder.

When the compositions of this invention contain a separate photoactive component (PAC) the binder itself is usually not photoactive.

The photoactive component (PAC) usually is a compound that produces either acid or base upon exporsure to actinic radiation. If an acid is produced upon exposure to actinic radiation, the PAC is termed a photoacid generator (PAG). If a base is produced upon exposure to actinic radiation, the PAC is termed a photobase generator (PBG).

Suitable photoacid generators for this invention include, but are not limited to, 1) sulphonium salts (formula 6), 2) iodonium salts (formula 7), and 3) hydroxamic acid esters, such formula 8.

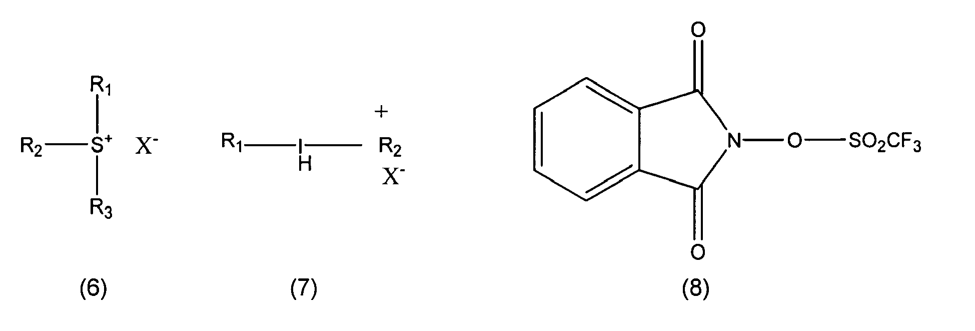

In formulas 6 and 7, R₁-R₃ are independently substituted or unsubstituted aryl or substituted or unsubstituted C₁-C₂₀ alkylaryl (aralkyl). Representative aryl groups include, but are not limited to, phenyl and naphthyl. Suitable substituents include, but are not limited to, hydroxyl (-OH) and C₁-C₂₀ alkyloxy (e.g., C₁₀H₂₁O). The anion X⁻ in formulas 6 and 7 can be, but is not limited to, SbF₆⁻ (hexafluoroantimonate), CF₃SO₃⁻(trifluoromethylsulfonate = triflate), and C₄F₉SO₃⁻ (perfluorobutylsulfonate).

### Dissolution Inhibitor

The dissolution inhibitors of this invention may satisfy multiple functional needs including dissolution inhibition, plasma etch esistance, plasticising and adhesion behavior of resist compositions.

The dissolution inhibitors (c) of the present invention comprise at least
(i) two aromatic groups
(ii) at least one fluorine atom, and
(iii) a (blocked) acid group which when unblocked has a pKa < 12.

Preferably, the dissolution inhibitor of the present invention comprises 2 to 5 aromatic groups, more preferably two or four aromatic groups as these are readily available.

The aromatic groups may be 5 or 6 membered rings, preferably 6 membered rings. Generally, these rings are fully hydrocarbon rings but they may contain oxygen or nitrogen, in particular oxygen as ether groups.

The dissolution inhibitor contains at least one fluorine atom, preferably 2 or more. The dissolution inhibitor preferably contains a fluorine at or near the aromatic ring structure.

Preferably, the acid group is an hydroxy group attached to the aromatic group or a tertiary OH group as in C[CF₃CF₃]OH. Preferably, the dissolution inhibitor comprises two or more acid groups. Generally, the dissolution inhibitor will have 5 acid groups or less.

The pKa of the acid group is about 12 or less, preferably about 10 or less, most preferred 9.6 or less. Generally, the pKa is about 2, or higher.

The acid groups preferably are partly or fully blocked with an acid-labile group. Preferably, at least 2 acid groups are blocked for 90% or more.

A acid labile protecting group may be selected such that when a photoacid is produced upon imagewise exposure, the acid will catalyze deprotection and production of hydrophilic acid groups that are necessary for development under aqueous conditions. Acid labile R groups include, but are not limited to A) a carbonate formed from a tertiary aliphatic alcohol, B) a tertiary aliphatic or other group which forms a stabilized carbocation, C) an acetal group and D) an orthoester group. Generally, groups A, B , C or D contain 3 to about 25 carbon atoms.

Some specific examples in category A are t-butyl, 2-methyl-2-adamantyl, and isobornyl carbonates.

Some specific examples in category B are t-butyl, 2-methyl-2-adamantyl, cyclopropylcarbinyl, 2-propenyl, and 2-trimethylsilylethyl.

Some specific examples in category C are 2-tetrahydropyranyl, 2-tetrahydrofuranyl, and alpha-alkoxyalkyl such as methoxymethyl and ethoxymethyl.

Some specific examples in category D are timethylorthoformate, triethylorthoformate, tripropylorthoformate, trimethylorthoacetate, triethylorthoacetate, tripropylorthoacetate.

Particularly preferred dissolution inhibitors are derivatives from bisphenol. Bisphenol has the general structure of formula 9 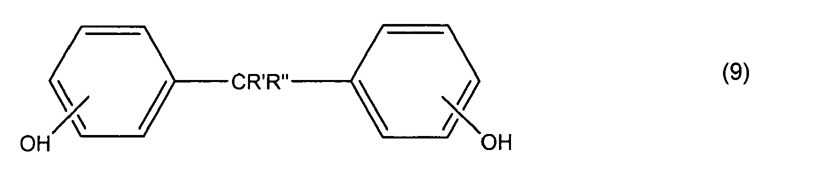 in which R' and R" are independently H or alkylgroups. Generally, the alcohol groups are in the para-position with respect to the bridging carbon atom. The sulphoxide analogue is also suitable in the present invention.

Preferably, the aromatic groups have hydrogen or fluorine atoms apart from the hydroxy and the bridging group.

The bridging group preferably is a fluorine substituted alkylene group such as for example bridging groups wherein R' or R" or both can be represented by a (CX₂)ₙ-Y group in which Y = H or F and wherein n= 0-20, or by a (CX₂)ₙ-O-(CX₂)ₙ-)ₘY group in which Y = H or F and wherein n= 0-20 and m = 0-10.

Suitable bridging groups are for example:
(a) C H (CF₂)ₙ C F₃ in which n = 0-10
(b) C H (CF₂)ₙ CF₂H in which n = 0-10
(c) C{(CF₂)ₙCFₛ} {(CF₂)ₘ CF₃} in which n and m are independently 0-6?
(d) CH-CF₂-(OCF-CF₂)-F (in which n = 0-4)

Bridging groups with 4-16 fluor atoms are most preferred.

The photoresist composition generally will contain:
(a) about 50 to about 99.5 wt% polymeric binder
(b) about 0 to about 10 wt% photoactive compound
(c) about 0.5 to about 50 wt% dissolution inhibitor relative to the total of (a) + (b) + (c).

The photoresist composition preferably contains less than about 99 wt% polymeric binder, more preferably less than about 95 wt%.

The photoresist composition preferably contains about 1-5 wt% of photoactive compound.

The photoresist compostion preferably contains about 1 wt% or more of dissolution inhibitor, more preferably about 5% or more. Generally, the amount of dissolution inhibitor will be about 50 wt% or less, more preferably about 20 wt% or less.

The photoresist composition of the present invention preferably has at 157 nm an absorption coefficient of less than about 3 µm⁻¹. More preferably below 2 µm⁻¹, and even more preferably below 1 µm⁻¹.

The dissolution inhibitor of the present invention, when used at 10 wt% in a polymeric binder preferably adds about 0.8 µm⁻¹ or less to the absorbance coefficient of the photoresist composition, more preferably less than about 0.6 µm⁻¹.

A dissolution inhibiting amount of the dissolution inhibitor is combined with the binder, solvent and any photoresist additives. Examples of a suitable solvent are 2-heptanone or PGMEA (propylene glycol methyl ether acetate).

### Other components

The compositions of this invention can contain optional additional components. Examples of additional components which can be added include, but are not limited to, resolution enhancers, adhesion promoters, residue reducers, coating aids, plasticizers, and Tg (glass transition temperature) modifiers. Crosslinking agents may also be present in negative-working resist compositions. Some typical crosslinking agents include bis-azides, such as 4,4'-diazidodipheyl sulphide and 3,3'-diazidodiphenyl sulfone. Typically, a negative working composition containing at least one crosslinking agent also contains suitable functionality (e.g., unsaturated C = C bonds) that can react with the reactive species (e.g., nitrenes) that are generated upon exposure to UV to produce crosslinked polymers that are not soluble, dispersed, or substantially swollen in developer solution.

### Process for forming an etched laver in a chip

The process for forming an etched layer in a chip comprises, in order:
(A) forming a photoresist layer on a substrate
   wherein the photoresist layer is prepared from a photoresist composition comprising:
   (a) a binder;
   (b) a photoactive component; and
   (c) the at least one dissolution inhibitor, the dissolution inhibitor comprising at least (i) two aromatic groups (ii) fluorine, and (iii) a (blocked) acid group which when unblocked has a pKa < 12.
(B) imagewise exposing a photoresist layer to form imaged and non-imaged areas
(C) developing the exposed photoresist layer having imaged and non-imaged areas to form the relief image on the substrate
(D) etching the substrate to predetermined depth
(E) removing the relief image on the substrate

The photoresist layer is prepared by applying a photoresist composition onto a substrate and drying to remove the solvent. The so formed photoresist layer is sensitive in the ultraviolet region of the electromagnetic spectrum and especially to different UV wavelengths including, 10-165 nm, in particular 13 or 157 nm. Imagewise exposure is for example done with ultraviolet light of 157 nm. Imagewise exposure can either be done digitally with a laser or equivalent device or non-digitally with use of a photomask? Digital imaging with a laser is preferred. Suitable laser devices for digital imaging of the compositions of this invention include, but are not limited to, a fluorine (F₂) laser with output at 157 nm. Since, as discussed supra, use of UV light of lower wavelength for imagewise exposure corresponds to higher resolution (lower resolution limit), the use of a lower wavelength 157 m is generally preferred over use of a higher wavelength (e.g., 248 nm or higher).

The photoresist compositions of this invention must contain sufficient functionality for development following imagewise exposure to UV light. Preferably, the functionality is an acid or protected acid such that aqueous development is possible using a basic developer such as sodium hydroxide solution, potassium hydroxide solution, or ammonium hydroxide solution.

When an aqueous processable photoresist is coated or otherwise applied to a substrate and imagewise exposed to UV light, development of the photoresist compsition may require that the binder material or dissolution inhibitor should contain sufficient acid groups and/or protected acid groups that are at least partially deprotected upon exposure to render the photoresist (or other photoimageable coating composition) processable in aqueous alkaline developer. In case of a positive-working photoresist layer, the photoresist layer will be removed during development in portions which are exposed to UV radiation but will be substantially unaffected in unexposed portions during development by aqueous alkaline liquids such as wholly aqueous solutions containing 0.262 N tetramethylammonium hydroxide (with development at 25°C usually for less than or equal to 120 seconds). In case of a negative-working photoresist layer, the photoresist layer will be removed during development in portions which are unexposed to UV radiation but will be substantially unaffected in exposed portions during development using either a critical fluid or an organic solvent.

A critical fluid, as used herein, is one or more substanced heated to a temperature near or above its critical temperature and compressed to a pressure near or above its critical pressure. Critical fluids in this invention are at least at a temperature that is higher than 15°C below the critical temperature of the fluid and are at least at a pressure higher than 5 atmosphers below the critical pressure of the fluid. Carbon dioxide may be used for the critical fluid in the present invention. Various organic solvents can also be used as developer in this invention. These include, but are not limited to, halogenated solvents and non-halogenated solvents. Halogenated solvents are typical and fluorinated solvents are more typical.

Etching of the substrate is performed by generally known means. Depending on the substrate, different etching substances may be used, as described in Soane, D.S., Martynenko, Z. "Polymers in Microelectronics: Fundamentals and Applications", Elsevier, Amsterdam, 1989.

Stripping the residual relief image is generally performed by using methods described in the above mentioned Soane reference.

In the process of forming patterned microelectronic structures by means of lithography, it is common in the art to use at least one antireflective layer either beneath the photoresist layer, a BARC, or on top of the photoresist layer, a TARC, (or sometimes referred to simply as an ARC) or both. Antireflective coating layers have been shown to reduce the deleterious effects of film thickness variations, and the resulting standing waves caused by the interference of light reflecting form various interfaces within the photoresist structure, and the variations in the exposure dose in the photoresist layer due to loss of the reflected light. The use of an antireflective layer results in improved patterning and resolution characteristics of the photoresist materials because it suppresses reflection related effects.

With the photoresists of the present invention it is possible to achieve a minimum feature size of 60 nm (1:1) at 140 nm thickness with a 157 nm laser. At 200 nm thickness a minimum feature size of 80 nm (1:1) was achieved. Without the dissolution inhibitor, it was impossible to get any suitable results with the same binder. Depending on the optics used, the feature size can be optimised.

The photoresist preferably has a critical energy amount (the point where the exposed area gets soluble) less than 10 mJ/cm², preferably less than 8 mJ/cm².

The thickness of the resist layer preferably is 100-400 nm, more preferably 150-300, and even more preferred 160-250 nm.

### Substrate

The substrate employed in this invention can be any material used in semiconductor manufacture, for example, silicon, silicon oxide, silicon nitride and the like.

### Other applications

The composition of the present invention can also be used as antireflective coatings.

Such antireflective layers may be applied using many different techniques such as spin coating, chemical vapor deposition and aerosol deposition. The formulation of antireflective compositions is well known to those skilled in the art. The primary optical properties of the composition being used for the antireflective layer to be considered are the optical absorption and the index of refraction.

The invention will be elucidated by the following non-binding examples.

### Immersion lithography.

The compositions according to the invention and further composition for producing a photoresist, provided the composition comprises a fluor compound are also suitable for use in immersion lithography at all wavelenth below 250 nm.

In immersion lithography a fluid is inserted between the last lens element and the photoresist. In this way chips can be produced using a higher level of integration.

A disadvantage of the known process is that the fluid adversely affects the quality of the photoresist. For example it is possible that components are extracted from the photoresist by the fluid. In this way both the quality of the photoresist ant the quality of the fluid are negatively influenced.

One way of finding a solution for this problem is by applying a protective top coat on the photoresist layer.

This however is a complicated way of doing, as an extra process step in the preparation of the chip is necessary.

A simple solution for the problem of the immersion fluid adversely affecting the photoresist is provided.

The solution is providing a process for producing chips, using immersion lithography, comprising the step of forming a photoresist layer on a substrate wherein the photoresist layer is prepared from a photoresist composition comprising:
(a) a binder;
(b) a photoactive component.
(c) a fluor containing compound.

Surprisingly in the process according to the invention the photoresist is in lesser degree or even not at all affected by the fluid. This is especially true for immersion lithography at 193 nm, using water as the immersion fluid. Photoresist compositions for 193 nm in general comprise acrylic and methacrylic binders.

### EXAMPLES

### Synthesis of various dissolution inhibitors. Chemical structures 10-15 represent the various Dls prepared in this study.

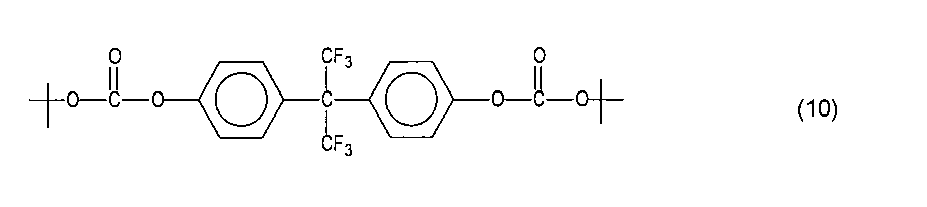

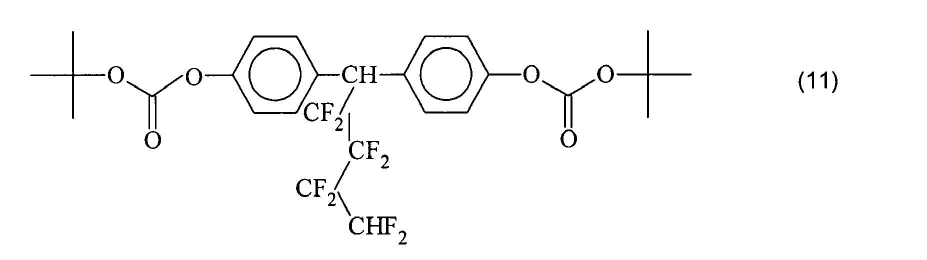

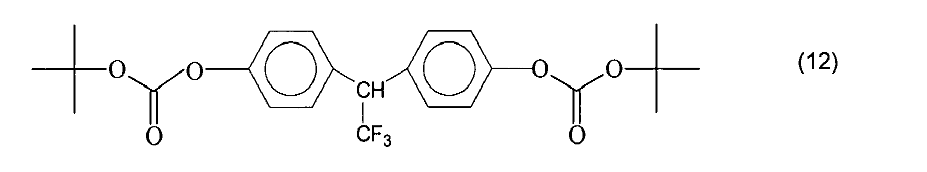

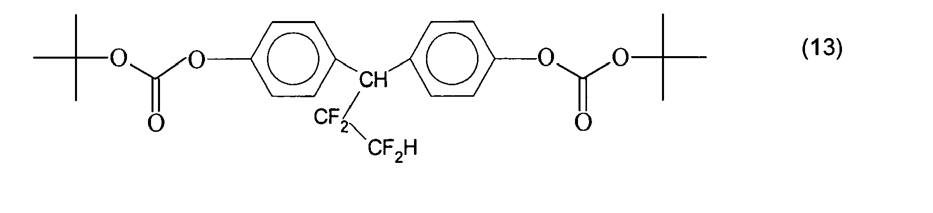

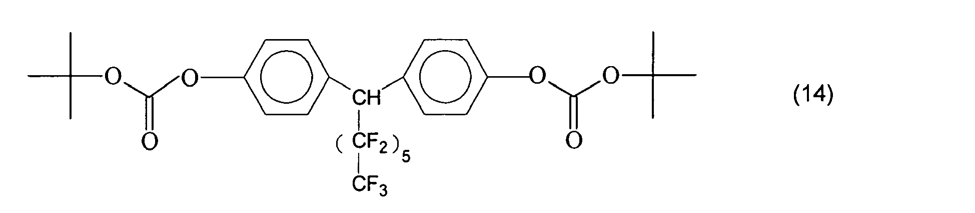

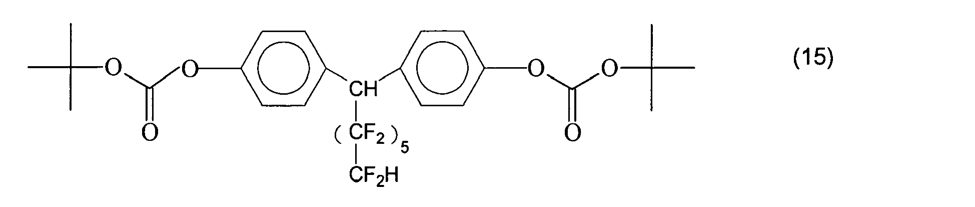

The syntheric procedure for the preparation of Dl according to formulas (10) is given below:

### bis-(tert-butyl) carbonate of 4,4'(hexafluoroisopropylidine)diphenol (10)

In acetonitrile (1.2 L) was dissolved 4,4'(hexafluorisopropylidine)diphenol (1) (24 g, 71.4 mmol) and di-*tert*-butyl dicarbonate (37 g, 171.4 mmol). To the clear solution was added DMAP (1.7 g, 14.3 mmol). After stirring for 3h at RT the reaction mixture was diluted with EtOAc (3 L) and washed with 5% HCl (aq) (300 mL). The organic layer was separated, dried with Na₂SO₄ and concentrated to a white/yellow solid which was recrystallized from MeOH. Compound (10) (31.3 g, 82 %) was obtained as a white solid. 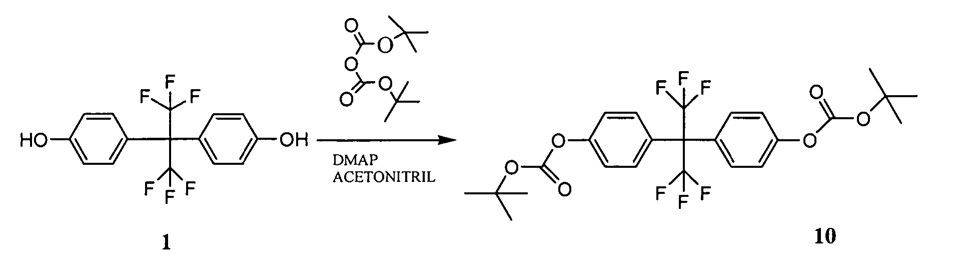 Other dissolution inhibitords (11)-(15) were obtained in an analogous manner.

### Preparation of various compositions.

Different formulations were prepared using polynorbornenehexafluoroalcohol (PNBHFA) as the base polymer (see formula 16). This polymer is prepared according to the procedure given by Tran et al. Macromolecules 2002 35 pp 6539-6549.

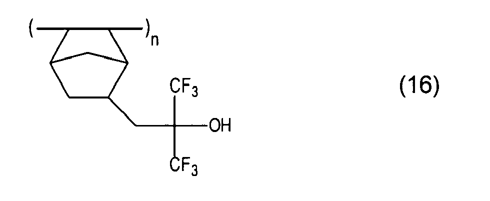

All the formulations were prepared using propylene glycol methyl ether acetate (PGMEA) as the solvent. A typical formulation consisted of the polymer with 5 wt % (relative to polymer) of photoacid generator (PAG), i.e. triphenylsulfonium nonaflate, and 0.3 wt % of base, i.e. tetrabuthylammonium hydroxide (TBAH), and appropriate amount of Dl. Tables 1 and 2 show the composition of all the formulations.

**Table 1. Composition of formulations.**

| **Formulation^{a}** | **DI** (wt %) | **PAG^{b}** | **Base^{c}** | **A_{157 nm}(µm⁻¹)** | **E0 (mJ/cm²)** |
|---|---|---|---|---|---|
| 1^{f} | - | - | - | 1.7 | - |
| 2 | 10% DI (10) | 5 | 0.3 | 2.3 | 5.9 |
| 3 | 15 % DI (10) | 5 | 0.3 | 2.5 | 5.3 |
| 4 | 10 % DI (11) | - | - | 2.0 | - |
| 5 | 10 % DI (11) | 5 | 0.3 | 2.4 | 5.6 |
| 6 | 15 % DI (11) | 5 | 0.3 | 2.4 | 6.8 |

| | | | | | |
|---|---|---|---|---|---|
| *a) All the formulations are based on PNBHFA* as *the platform polymer.* *b) Weight percentage of PAG, i.e. triphenylsulfonium nonaflate, relative to polymer + Dl* *c) Weight percentage of base, i.e. tetrabuthylammonium hydroxide (TBAH), relative to polymer + Dl* | | | | | |

**Table 2.**

| **Formulation^{a}** | **DI (wt%)** | **PAG^{b}** | **A_{157 nm}(µm⁻¹)** | **E0(mJ/cm²)** | **Dark loss (Å)** |
|---|---|---|---|---|---|
| 7 | 10% (10) | 5 | 1.97 | 2.1 | 186 |
| 8 | 10% (11) | 5 | 1,95/7 | 5.0/3.9 | 115/108 |
| 9 | 10% (12) | 5 | 2.08 | 2.9 | 193 |
| 10 | 10% (13) | 5 | 2.02 | 2.9 | 176 |
| 11 | 10% (14) | 5 | 1.90 | 7.8 | 96 |
| 12 | 10% (15) | 5 | 1.92 | 6.7 | 92 |

| | | | | | |
|---|---|---|---|---|---|
| *a) All the formulations are based on PNBHFA* as *the platform polymer and 0.3 wt% Base relative to polymer + D1* *b) Weight percentage of PAG, i.e. triphenylsulfonium nonaflate, relative to polymer + DI* | | | | | |

The results show that the absorbance at 157 nm is low, and that the dissolution inhibitor adds 0.2-0.8 µm⁻¹ absorbance at 10-15%. The critical energy (Eo) is a measure for the energy needed to make the composition soluble in the developper solution. The dark loss is the loss in A of the composition by the developper solution. The figures show the imaging results of formulations 3, 5 and 6.

Further, the oxide etch resistance with a C₄F₈ recipe was tested of formulations 7 and 8, in comparison with a reference p-hydroxy styrene commercial system, and in comparison with 15% of compound 6 of the Conley et al. reference mentioned in the introduction; this is an aliphatic dissolution inhibitor. The relative etch results of the compounds of the invention showed a 6-7% inprovement over the commercial standard, and a 3% improvement over the aliphatic dissolution inhibitor, while using only 10% of aromatic dissolution inhibitor in stead of the 15% aliphatic dissolution inhibitor.

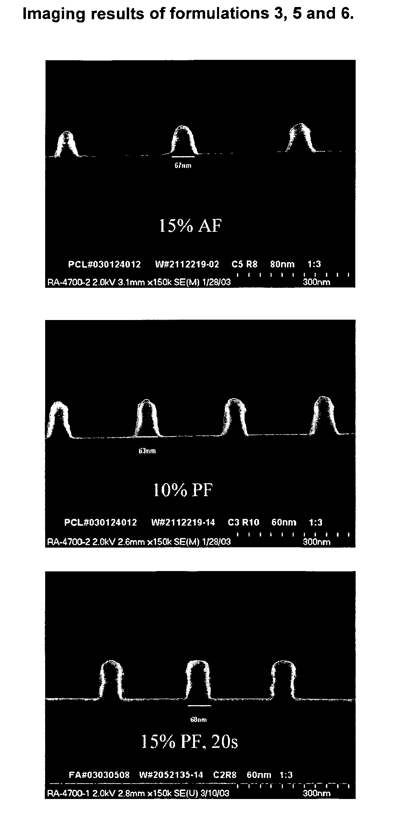

## Claims

1. A process for the production of a chip by using immersion lithography, comprising the step of forming a photoresist layer on a substrate, wherein the photoresist layer is prepared from a photoresist composition comprising:
(a) a binder;
(b) a photoactive component.
(c) a fluor containing compound.

2. Process for forming an etched layer in a chip by using immersion lithography comprising, in order:
(A) forming a photoresist layer on a substrate wherein the photoresist layer is prepared from a photoresist composition comprising:
(a) a binder;
(b) a photoactive component; and
(c) a fluor containing compound
(B) imagewise exposing a photoresist layer to form imaged and non-imaged areas,
(C) developing the exposed photoresist layer having imaged and non-imaged areas to form the relief image on the substrate
(D) etching the substrate to a predetermined depth
(E) removing the relief image from the substrate.

3. Process according to any one of claims 1-2, wherein the photoresist composition comprises (c) a fluor containing compound excluding Megafac F176, Megafac R08, and PA-6520 from Omnova Solution

4. Process according to any one of claims 1-2, wherein the photoresist composition comprises (c) a fluor containing compound excluding fluor containing surfactants

5. Process according to any one of claims 1-4, wherein the photoresist composition comprises (c) a fluor containing compound having a (blocked) acid group, which when unblocked has a pKa < 12.

6. Process according to any one of claims 1-5, wherein the photoresist composition comprises (c) a fluor containing compound having two or more acid groups.

7. Process according to any one of claims 1-6, wherein the photoresist composition comprises (c) a fluor containing compound having an acid group with a pKa of 9.6 or less

8. Process according to any one of claims 1-7, wherein the photoresist composition comprises (c) a fluor containing compound having acids groups which are partly or fully blocked with acid-labile groups

9. Process according to claim 8, wherein the photoresist composition comprises (c) a fluor containing compound having at least partly blocked acid-labile groups, chosen from the group consisting of A) a carbonate formed from a tertiary aliphatic alcohol, B) a tertiary aliphatic or other group which forms a stabilized carbocation, C) an acetal group and D) an orthoester group.

10. Process according to any one of claims 1-8, wherein the photoresist composition comprises (c) a fluor containing compound having aromatic groups.

11. Process according to any one of claims 1-10, wherein the photoresist composition comprises (a) 50 to 99.5 wt% of a polymeric binder

12. Process according to any one of claims 1-11, wherein the photoresist composition comprises (b) 0 to about 10 wt% photoactive compound

13. Process according to any one of claims 1-12, wherein the photoresist composition comprises a binder, which is a polymer comprising acid groups with a pKa , 12

14. Process according to claim 13, wherein the acid groups are partially blocked.

15. Process according to any one of claims 5-14 wherein the acid group is an hydroxyl group bound to an aromatic group, or a C(CF₃)₂ OH bound to an aromatic ring.

16. Process according to any one of claims 5-15 wherein the acid group is at least partly blocked with a carbonate, acetal group, ortho ester, or tertiary alkyl group.

17. Process according to any one of claims 5-16, wherein the photoresist composition comprises (a) a binder comprising fluorine groups

18. Process according to any one of claims 1-18, wherein the photoresist composition comprises (a) a polymer with ring structures

19. Process according to any one of claims 1-18, wherein the process is performed at 193 nm.

20. Process according to any one of claims 1-19, wherein the photoresist composition comprises (a) an acrylic or methacrylic binder.
